# EUROPÄISCHE PATENTANMELDUNG

(11) **EP 2 078 964 A1**
(43) Veröffentlichungstag der Anmeldung: **15.07.2009**
(21) Anmeldenummer: 09000439.1
(22) Anmeldetag: 14.01.2009
(51) Int. Cl.: G01R 1/04, G01R 1/067

(54) **Anschlußkontakt, IC Testsockel und Verfahren**

(30) Priorität: 14.01.2008 DE 102008004162
(71) Anmelder: Yamaichi Electronics Deutschland GmbH, 81829 München (DE)
(72) Erfinder: Quiter, Michael, 85560 Ebersberg (DE)
(74) Vertreter: Müller-Boré & Partner Patentanwälte

(57) **Zusammenfassung**

Zusammengefaßt betrifft die vorliegende Erfindung einen Anschlußkontakt (10) für einen IC-Testsockel umfassend:
- einen Kontaktstift (12) mit
-- einem Federkontaktbereich (18), der ausgelegt ist, ein Federelement (14) zu kontaktieren,
-- einem IC-Kontaktbereich (28), der ausgelegt ist, einen IC zu kontaktieren und mit
-- einem Federbefestigungsbereich (24), wobei

der Kontaktstift (12) einstückig ausgebildet ist, und wobei der Anschlußkontakt weiterhin
- ein Federelement (14) mit
-- einem Kontaktstiftbefestigungsbereich (36) umfaßt, wobei

der Federbefestigungsbereich (24) und der Kotaktstiftbefestigungsbereich (36) derart miteinander verbunden sind, daß der Kontaktstift (12) und das Federelement (14) aneinander fixiert sind sowie einen IC-Testsockel und ein Verfahren zum Herstellen.

## Beschreibung

Die vorliegende Erfindung betrifft einen Anschlußkontakt für einen IC-Testsockel, einen IC-Testsockel und ein Verfahren zum Herstellen.

Herkömmlicherweise werden Anschlußkontakte für integrated circuit (IC)-Testsockel derart verwendet, daß eine Vielzahl dieser Anschlußkontakte matrixartig in dem IC-Testsockel angeordnet sind. Ein jeder der Anschlußkontakte kontaktiert in betriebsmäßigem Gebrauch einen entsprechenden Kontakt des ICs. Weiterhin kontaktiert jeder Anschlußkontakt eine Auswerteeinrichtung, insbesondere eine Leiterplatte, die mit einer Meßeinrichtung signaltechnisch verbunden ist. Der Anschlußkontakt ist herkömmlicherweise in dem IC-Testsockel rückstellfähig gelagert, so daß der Anschlußkontakt mit dem IC in elektrischen Kontakt treten kann, wenn der IC beispielsweise von oben auf den IC-Testsockel aufgesetzt wird, ohne daß der Anschlußkontakt mit dem IC verlötet werden muß.

Aufgrund der kleinen Abmessungen sind herkömmliche Anschlußkontakte manuell gefertigt. Herkömmliche Anschlußkontakte bestehen aus einem Gehäuse, in dem ein Kontaktpin zum Kontaktieren des ICs untergebracht ist. Ferner ist ein Kontaktpin zum Kontaktieren der Auswerteeinrichtung in dem Gehäuse untergebracht. Das Gehäuse ist herkömmlicherweise in etwa hohlzylinderförmig ausgebildet, wobei die beiden Kotaktpins an gegenüberliegenden Enden aus dem Gehäuse hervorragen. Zwischen den Kontaktpins ist eine Feder angeordnet, die die beiden Kontaktpins voneinander weg drückt und insbesondere bewirkt, daß die beiden Kontaktpins aus dem Gehäuse hervorragen. Um den Anschlußkontakt herzustellen werden der erste Kontaktpin, die dazwischenliegende Feder und der zweite Kontaktpin in dem Hohlzylinder angeordnet und die Enden des Hohlzylinders verjüngt, so daß die Kontaktpins zwar beweglich sind, jedoch den Hohlzylinder nicht vollständig verlassen können.

Wird ein IC an dem Testsockel angeordnet, drückt der Kontaktpin aufgrund der Federkraft gegen den IC, wodurch ein Kontakt zwischen dem Kontaktpin und dem IC erfolgt.

Entsprechend drückt der andere Kontaktpin gegen die Auswerteeinrichtung. Zum Testen des ICs kann ein Signalaustausch zwischen dem IC und der Auswerteeinrichtung erfolgen, wobei das Signal ausgehend von dem IC über den ersten Kontaktpin, das Gehäuse und den zweiten Kontaktpin zu der Auswerteeinrichtung geleitet wird (und umgekehrt). Signale zum Testen von ICs sind regelmäßig sehr empfindlich.

Es ist daher eine Aufgabe der vorliegenden Erfindung, daß ein Anschlußkontakt mit guter Signalübertragung in einfacher und sicherer Weise herstellbar ist. Diese Aufgabe wird gelöst durch den Anschlußkontakt gemäß Anspruch 1, den IC-Testsockel gemäß Anspruch 13 und das Verfahren zur Herstellung des Anschlußkontakts gemäß Anspruch 14. Bevorzugte Ausführungsformen sind Gegenstand der abhängigen Ansprüche.

### Anschlußkontakt gemäß einem Aspekt

Ein Aspekt der vorliegenden Erfindung betrifft einen Anschlußkontakt für einen IC-Testsockel umfassend:
- einen Kontaktstift mit
   -- einem Federkontaktbereich, der ausgelegt ist, ein Federelement zu kontaktieren,
   -- einem IC-Kontaktbereich, der ausgelegt ist, einen IC zu kontaktieren und mit
   -- einem Federbefestigungsbereich, wobei der Kontaktstift einstückig ausgebildet ist, und wobei der Anschlußkontakt ferner
- ein Federelement mit
   -- einem Kontaktstiftbefestigungsbereich umfaßt, wobei
   der Federbefestigungsbereich und der Kotaktstiftbefestigungsbereich derart miteinander verbunden sind, daß der Kontaktstift und das Federelement aneinander fixiert sind.

Der Begriff "einstückig" beschreibt, daß der Kontaktstift in dem Anschlußkontakt eine einzige, zusammenhängende Einheit bildet. Hierbei kann der Kontaktstift in einem Stück gefertigt werden, z.B. als ein Stück gegossen, gezogen, gespritzt werden usw. Der Kontaktstift kann auch mehrere Elemente aufweisen, die miteinander verbunden sind beispielsweise ineinander gesteckt, insbesondere gepreßt sind und/oder miteinander verklebt, verlötet verschweißt sind, usw. Beispielsweise können der IC-Kontaktbereich und der Federkontaktbereich zwei separate Bauteile sein, die jedoch miteinander verbunden sind. Die beiden Bauteile können z.B. mittels des Federbefestigungsbereichs (als weiterem separaten Bauteil) miteinander verbunden sein, so daß der Kontaktstift eine Einheit bildet.

Der Begriff "IC" steht für "integrated circuit". Ein IC kann beispielsweise Bestandteil eines Mikroprozessors sein. Ein IC kann auch Bestandteil einer anderweitigen elektronischen bzw. elektrischen Einrichtung sein. Ein IC kann insbesondere jegliche Art sogenannter "embedded electronic" umfassen bzw. deren Bestandteil sein.

Der IC-Kontaktbereich ist insbesondere ausgelegt, einen Kontaktpunkt bzw. ein Kontaktelement des ICs zu kontaktieren. Der IC kann eine Vielzahl von Kontaktelementen aufweisen. Die Kontaktelemente können vorzugsweise matrixartig angeordnet sein. Jedes Kontaktelement kann z.B. einen Lotpunkt oder eine ähnliche Ausgestaltung aufweisen, die der IC-Kontaktbereich kontaktieren kann. Insbesondere ist es möglich, daß der IC-Kontaktbereich zumindest teilweise in das Kontaktelement eindringt. Dies ist beispielsweise möglich, wenn das Kontaktelement ein Metall oder ein anderes leitfähiges Material umfaßt, das vorzugsweise weicher ist, als der IC-Kontaktbereich, so daß durch Ausüben einer Kraft der IC-Kontaktbereich in das Kontaktelement zumindest teilweise eindringen kann. Somit wird vorteilhafterweise ein besonders guter elektrischer und/oder mechanischer Kontakt zwischen dem IC-Kontaktbereich und dem Kontaktelement des ICs ermöglicht.

Vorteilhafterweise kann der Anschlußkontakt in einfacher und zuverlässiger Weise hergestellt werden, da es insbesondere nicht notwendig ist, Bauelemente des Anschlußkontakts, wie z.B. Kontaktpins und Feder in einem Gehäuse anzuordnen. Vielmehr kann in einfacher Weise das Federelement an dem Kontaktstift befestigt werden, wodurch der Anschlußkontakt bereits hergestellt ist. Insbesondere vorteilhafterweise ist der Anschlußkontakt somit manuell in einfacher und zuverlässiger Weise herstellbar, da lediglich der Kontaktstift in das Federelement geschoben werden muß und der Federkontaktbereich und der Kontaktstiftkontaktbereich miteinander verbunden werden müssen. Der Federkontaktbereich und der Kontaktstiftkontaktbereich können hierbei einen Formschluß und/oder Kraftschluß aufweisen. Insbesondere können Federkontaktbereich und der Kontaktstiftkontaktbereich miteinander verpreßt verschweißt, verlötet sein, usw. Somit ist es weiterhin vorteilhafterweise möglich, daß auch bei Anlegen einer Kraft an dem Federelement und/oder dem Kontaktstift die Verbindung zwischen Federkontaktbereich und der Kontaktstiftkontaktbereich erhalten bleibt. In anderen Worten beschreibt der Begriff "fixiert", daß an Kontaktstift und Federelement entgegengesetzt gerichtete Kräfte angelegt werden können, wobei die Verbindung erhalten bleibt, wenn eine Kraft zwischen etwa 0,01 N und etwa 5 N angelegt wird, d.h. das Federelement und der Kontaktstift nicht voneinander getrennt werden. Die Kraft kann vorzugsweise größer als etwa 0,05 N, größer als etwa 0,1 N, größer als etwa 0,2 N, größer als etwa 0,5 N, größer als etwa 1 N sein. Die Kraft kann geringer als etwa 4 N, geringer als etwa 3 N, geringer als etwa 2 N, geringer als etwa 1,5 N sein.

Weiterhin vorteilhafterweise wird somit eine elektrische Signalübertragung zwischen dem IC und einer Auswerteeinrichtung verbessert, da die Anzahl der elektrischen Übergangskontakte, die das Signal von dem IC zu der Auswerteeinrichtung über den Anschlußkontakt passieren muß, verglichen zu einem herkömmlichen Anschlußkontakt mit zwei in einem Gehäuse angeordneten Kontaktpins, verringert wird (siehe unten).

### Bevorzugte Ausführungsformen des Anschlußkontakts

Vorzugsweise weist der IC-Kontaktbereich zumindest sechs Kontaktspitzen auf und die Kontaktspitzen sind ausgelegt, ein Kontaktelement eines ICs zu kontaktieren.

Der IC-Kontaktbereich kann auch mehr als sechs Kontaktspitzen, z.B. 8, 10, 12, usw. Kontaktspitzen aufweisen. Vorteilhafterweise wird somit erreicht, daß der IC-Kontaktbereich ein Kontaktelement des ICs zuverlässig kontaktiert, wobei insbesondere ein guter elektrischer Kontakt mit einem geringen Kontaktwiderstand erreicht wird und daher auch eine verbesserte Signalübertragung.

Vorzugsweise weist der IC-Kontaktbereich zumindest sechs Kontaktkanten auf, wobei die Kontaktkanten zumindest bereichsweise ausgelegt sind, ein Kontaktelement eines ICs zu kontaktieren.

Der IC-Kontaktbereich kann auch mehr als sechs Kontaktkanten, z.B. 8, 10, 12, usw. Kontaktkanten aufweisen. Vorteilhafterweise wird somit erreicht, daß der IC-Kontaktbereich ein Kontaktelement des ICs zuverlässig kontaktiert, wobei insbesondere ein guter elektrischer Kontakt mit einem geringen Kontaktwiderstand erreicht wird und somit auch eine verbesserte Signalübertragung. Hierbei kann jede Kontaktkante den Kontaktbereich zumindest bereichsweise kontaktieren. Es ist auch möglich, daß jede Kontaktkante den IC bzw. ein Kontaktelement des IC im wesentlichen entlang der gesamten Länge der Kontaktkante kontaktiert. Somit wird eine Kontaktlänge der Kontaktkanten mit dem Kontaktelement erhöht, wodurch der mechanische und/oder elektrische Kontakt verbessert wird, insbesondere der ohmsche Kontaktwiederstand zwischen den Kontaktkanten und dem Kontaktelement des ICs verringert und somit auch eine verbesserte Signalübertragung erreicht.

Vorzugsweise weist der IC-Kontaktbereich zumindest zwölf Kontaktflächen auf und die Kontaktflächen sind zumindest bereichsweise ausgelegt, ein Kontaktelement eines ICs zu kontaktieren, insbesondere kapazitiv mit einem Kontaktelement eines ICs gekoppelt zu sein.

Der IC-Kontaktbereich kann auch mehr als zwölf Kontaktflächen, z.B. 14, 16, 18, 20, usw. Kontaktflächen aufweisen. Vorteilhafterweise wird somit erreicht, daß der IC-Kontaktbereich ein Kontaktelement des ICs zuverlässig kontaktiert, wobei insbesondere ein guter elektrischer Kontakt mit einem geringen Kontaktwiderstand erreicht wird. Weiterhin vorteilhafterweise wird aufgrund der Vielzahl der Kontaktflächen eine hohe kapazitive Kopplung des IC-Kontaktbereichs mit dem Kontaktelement des ICs erreicht. Folglich wird auch eine verbesserte Signalübertragung erreicht.
Vorzugsweise sind das Federelement und der Kontaktstift derart miteinander verbunden, daß der Anschlußkontakt gehäusefrei ist.

Vorteilhafterweise ist es somit möglich, den Anschlußkontakt in einfacher und kostengünstiger Weise herzustellen.

Vorzugsweise umfaßt das Federelement einen Kontaktbereich und der Kontaktbereich ist ausgelegt, ein elektronisches Bauelement, insbesondere eine Leiterplatine zu kontaktieren.

Vorteilhafterweise ist es nicht notwendig, den Anschlußkontakt mit einem weiteren, separaten Kontaktpin zu versehen, wodurch der Anschlußkontakt in einfacher und kostengünstiger Weise herstellbar ist. Vorteilhafterweise ist es insbesondere nicht notwendig, daß der Anschlußkontakt mit einem Gehäuse versehen ist.

Der Begriff "fixiert" beschreibt, daß der Federbefestigungsbereich des Federelements und der Kotaktstiftbefestigungsbereich des Kontaktstiftes vorzugsweise derart miteinander verbunden, daß bei Anlegen einer Kraft an dem Federelement mit einer zu einer Längsrichtung LR des Anschlußkontakts im wesentlichen parallelen Kraftkomponente zwischen etwa 0,1 N und etwa 2 N das Federelement und der Kontaktstift miteinander verbunden bleiben.

Der Anschlußkontakt ist vorteilhafterweise stabil genug ausgebildet, daß der Anschlußkontakt kein Gehäuse benötigt, d.h. gehäusefrei ist. Dies wird insbesondere dadurch erreicht, daß das Federelement und der Kontaktstift derart fest miteinander verbunden sind, d.h. das Federelement und der Kontaktstift derart aneinander fixiert sind (bzw. umgekehrt), daß beim bestimmungsgemäßen Gebrauch und auch bei der bestimmungsgemäßen Herstellung des Anschlußkontakts das Federelement und der Kontaktstift miteinander verbunden bleiben.

Vorzugsweise sind der Kontaktstift und das Federelement derart miteinander verbunden, daß der IC-Kontaktbereich außerhalb des Federelements angeordnet ist und der Federkontaktbereich zumindest teilweise, insbesondere vollständig innerhalb des Federelements angeordnet ist.

Vorteilhafterweise ist der IC-Kontaktbereich somit in einfacher Weise mit dem IC kontaktierbar. Durch die Anordnung des Federkontaktbereichs im Inneren des Federelements ist es vorteilhafterweise in einfacher Weise möglich, sicher zu stellen, daß der Federkontaktbereich in der Kontaktposition bzw. dem Kontaktzustand des Anschlußkontakts das Federelement kontaktiert. Somit ist in einfacher Weise ein zuverlässiger Signaltransport von dem Kontaktstift über das Federelement auf die Auswerteeinrichtung möglich.

Vorzugsweise weist der Kontaktstift zwischen dem IC-Kontaktbereich und dem Federkontaktbereich in radialer Richtung einen Vorsprung auf, wobei der Vorsprung derart ausgebildet ist, daß das Federelement entlang der Längsrichtung LR den Vorsprung nicht passieren kann.

Vorzugsweise ist der Vorsprung ein separates Element, das auf den Kontaktstift gepreßt ist bzw. mit dem Kontaktstift verpreßt ist. Es ist auch möglich, daß der Vorsprung in einer anderen Art und Weise mit dem Kontaktstift verbunden ist, z.B. kann der Vorsprung mit dem Kontaktstift verklebt, verlötet, verschweißt sein usw. Es ist auch möglich, daß der Kontaktstift (incl. Vorsprung) aus einem Stück gefertigt ist, beispielsweise gespritzt ist, gezogen ist, gepreßt ist, usw.

Vorteilhafterweise ist daher eine einfache und zuverlässige Montage des Federelements mit dem Kontaktstift möglich, da der Kontaktstift in ein Inneres des Federelements schiebbar ist, bis der Vorsprung an das Federelement stößt (bzw. umgekehrt das Federelement über den Kontaktstift geschoben werden, bis das Federelement gegen den Vorsprung stößt).

Die Längsrichtung LR ist beispielsweise eine Richtung, die parallel zu einer Längsachse des Kontaktstiftes und/oder des Federelements angeordnet ist. Beispielsweise kann die Längsrichtung LR parallel zu zumindest einer Zylinderachse des Kontaktstiftes und/oder des Federelements sein.

Vorzugsweise weist das Federelement zumindest drei Federelementbereiche auf, wobei das Federelement in einem inneren bzw. mittleren (in Hinsicht auf die Längsrichtung LR) Federelementbereich entlang der Längsrichtung LR stärker dehnbar und/oder stauchbar ist, als in den verbleibenden Federelementbereichen.

In anderen Worten kann der innere bzw. mittlere Bereich elastischer sein, als die verbleibenden Bereiche, d.h. die verbleibenden Bereiche können steifer sein als der innere bzw. mittlere Bereich. Ein verbleibender Bereich kann zum Beispiel den in den Figuren gezeigten Übergangsbereich und Kontaktstiftkontaktbereich umfassen. Ein weiterer verbleibender Bereich kann zum Beispiel der Kontaktstiftbefestigungsbereich sein.

Vorteilhafterweise kann der Übergangsbereich des Federelements, wie auch in den Figuren gezeigt ist, derart ausgelegt und ausgebildet sein, den Federkontaktbereich des Kontaktstiftes zu führen, damit bei einem gestauchtem Federelement der Federkontaktbereich mit einem Kontaktstiftkontaktbereich des Federelements in Kontakt ist. Hierdurch kann beispielsweise eine entstehende Betätigungskraft bzw. Reibkraft, welche entsteht wenn das Federelement mit dem Federkontaktbereich in Berührung/Kontakt kommt bzw. geführt wird, verringert werden. Insbesondere können die Materialien des Übergangsbereichs und/oder des Federkontaktbereichs derart gewählt sein, daß eine möglichst geringe Reibung zwischen dem Übergangsbereichs und dem Federkontaktbereich vorliegt. Ferner kann der Übergangsbereich aus einem entsprechend verwindungssteifen Material sein, so daß auch bei Anliegen einer Kraft durch den Federkontaktbereich dieser zuverlässig geführt werden kann. Insbesondere kann es möglich sein, daß im Übergangsbereich des Federelements dieses gehärtet und/oder aus einem vom Rest des Federelements, insbesondere von einem inneren Bereich des Federelements verschiedenen Material hergestellt ist.

Der Begriff "entlang" einer Richtung beinhaltet insbesondere parallel und/oder antiparallel zu dieser Richtung.

Vorzugsweise ist das Federelement eine Spiralfeder, wobei der Abstand der Spiralwindungen der Spiralfeder des inneren bzw. mittleren (in Hinsicht auf die Längsrichtung LR) Federelementbereichs größer ist als der Abstand der Spiralwindungen der anderen Federelementbereiche der Spiralfeder.

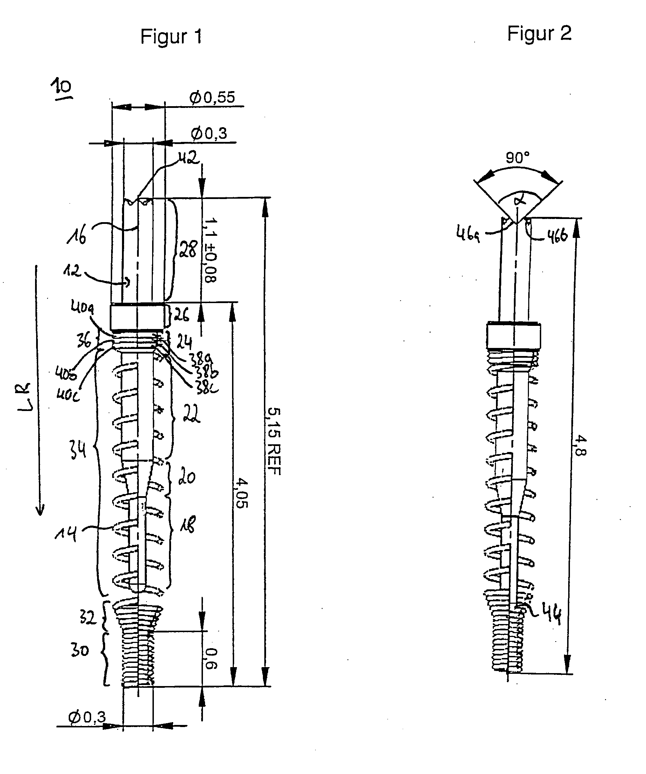

Vorzugsweise sind das Federelement und der Federkontaktbereich derart angeordnet und ausgebildet, daß in einem Ruhezustand (Figur 1) des Anschlußkontakts der Federkontaktbereich und das Federelement berührungslos sind.

Vorteilhafterweise kann somit - im Vergleich zu herkömmlichen Ausgestaltungen von Anschlußkontakten, in denen sich beispielsweise die entsprechenden Bereiche in einem Ruhezustand kontaktieren bzw. berühren - entstehende Reibung und Abrieb von Material zwischen den Kontaktflächen des Federkontaktbereichs und des Federelements minimiert werden. Hierdurch kann die Standzeit eines Anschlußkontakts erhöht werden, wodurch zugleich die Qualität der Signale, welche mittels eines Anschlußkontakts beim Einsatz in einem IC-Testsockel abgegriffen werden, über einen längeren Zeitraum konstant gehalten werden können. Insbesondere kann somit auch über eine lange Zeit und eine Vielzahl von Einsätzen des Anschlußkontakts eine zuverlässige elektrische Kontaktierung ermöglicht werden und ein zuverlässiger Betrieb bei bestmöglicher Signalübertragung sichergestellt werden.

Der Ruhezustand des Anschlußkontakts ist beispielsweise der Zustand, in dem an dem Anschlußkontakt im wesentlichen keine äußeren Kräfte anliegen. Beispielsweise kann der Ruhezustand des Anschlußkontakts vorliegen, wenn der Anschlußkontakt auf einer im Bezugssystem der Erde horizontalen Eben liegt, d.h. wenn die Längsachse des Anschlußkontakts, insbesondere die Längsachse des Kontaktstiftes, im wesentlichen parallel ist. Der Ruhezustand ist insbesondere der Zustand, in dem entlang der Längsachse des Federelements keine Kraft an dem Federelement anliegt, d.h. das Federelement entlang der Längsrichtung im wesentlichen nicht gestaucht und nicht gedehnt ist.

Vorzugsweise ist das Federelement entlang der Längsrichtung LR derart stauchbar, daß in einem Kontaktzustand der Federkontaktbereich zumindest eine Windung des Kontaktbereichs berührt.

### IC-Testsockel gemäß einem Aspekt

Ein Aspekt der vorliegenden Erfindung betrifft einen IC-Testsockel mit einem Gehäuse, das eine Vielzahl von Öffnungen aufweist, wobei
- in jeder Öffnung ein Anschlußkontakt gemäß einem der vorhergehenden Ansprüche angeordnet ist,
- die Öffnungen mittels einer gemeinsamen Abdeckung verschlossen sind,
- der Kontaktbereich eines jeden Anschlußkontakts entlang der Längsrichtung über das Gehäuse des IC-Testsockels hinausragt und wobei
- der IC-Kontaktbereich durch die Abdeckung hindurch ragt und entlang der Längsrichtung über das Gehäuse des IC-Testsockels hinausragt.

### Verfahren gemäß einem Aspekt

Ein Aspekt der vorliegenden Erfindung betrifft ein Verfahren zum Herstellen eines erfindungsgemäßen Anschlußkontakts mit den Schritten:
- Bereitstellen des Kontaktstiftes
- Bereitstellen des Federelements
- Einführen des Kontaktstiftes in das Federelement
- Verbinden des Kontaktstiftbefestigungsbereichs mit dem Federbefestigungsbereich.

Der Begriff "Einführen" beschreibt eine Relativbewegung, d.h. daß der Kontaktstift festgelegt ist und das Federelement relativ zu dem festgelegten Kontaktstift bewegt wird, insbesondere über den Kontaktstift geschoben wird. Alternativ ist das Federelement festgelegt und der Kontaktstift wird relativ zu dem festgelegten Federelement bewegt, insbesondere in das Federelement hinein geschoben. Alternativ werden sowohl das Federelement und der Kontaktstift geschoben.

### Bevorzugte Ausführungsformen des Verfahrens

Vorzugsweise wird der Kontaktstift soweit in das Federelement eingeführt, bis der Kontaktstiftbefestigungsbereich an den Vorsprung stößt.

Vorzugsweise stößt der Kontaktstiftbefestigungsbereich während des Verbindens von Federelement und Kontaktstift an den Vorsprung.

Die Erfindung ist nicht auf die oben beschriebenen Aspekte bzw. Ausführungsformen beschränkt. Vielmehr können einzelne Merkmale der Aspekte und/oder Ausführungsformen losgelöst von dem entsprechenden Aspekt bzw. der entsprechenden Ausführungsform beliebig miteinander kombiniert werden und insbesondere somit neue Ausführungsformen gebildet werden. In anderen Worten gelten die obigen Ausführungen zu den einzelnen Merkmalen der Vorrichtung sinngemäß auch für den IC-Testsockel sowie das Verfahren und umgekehrt.

### Figurenbeschreibung

Bevorzugte Ausführungsformen eines Anschlußkontakts werden nachfolgend anhand begleitender Figuren beispielhaft beschrieben. Es zeigt
- Figur 1:: eine Seitenansicht eines beispielhaften Anschlußkontakts;
- Figur 2:: eine Ansicht gemäß Figur 1;
- Figur 3:: eine Ansicht gemäß Figur 1;
- Figur 4:: eine Ansicht gemäß Figur 1;
- Figur 5:: eine Aufsicht eines Anschlußkontakts;
- Figur 6:: eine perspektivische Ansicht eines Anschlußkontakts.

Figur 1 zeigt einen Anschlußkontakt 10 mit einem Kontaktstift 12 und einer Feder 14 als bevorzugtem Federelement. Die Feder 14 ist zumindest bereichsweise aufgeschnitten dargestellt. Figur 1 zeigt den Anschlußkontakt 10 in einem im wesentlichen entspannten Zustand, d.h. an der Feder 14 liegt entlang einer Längsrichtung LR im wesentlichen keine Kraft an. In anderen Worten zeigt Figur 1 den Anschlußkontakt in dem Ruhezustand. Die Längsrichtung LR ist im wesentlichen parallel zu einer Symmetrieachse 16 des Anschlußkontakts 10. Der in Figur 1 gezeigte Kontaktstift 12 ist zumindest bereichsweise zylinderförmig ausgeführt. Vorzugsweise ist die Symmetrieachse 16 gleich einer Zylinderachse 16 der zylinderförmigen Bereiche des Kontaktstifts 12.

Der Kontaktstift 12 weist mehrere Bereiche auf. Insbesondere weist der Kontaktstift 12 einen Federkontaktbereich 18, einen Übergangsbereich 20, einen inneren bzw. mittleren Bereich 22, einen Federbefestigungsbereich 24, einen Vorsprungsbereich 26 und einen IC-Kontaktbereich 28 auf. Die Feder 14 ist vorzugsweise eine Spiralfeder 14, die einen Kontaktbereich bzw. Kontaktstiftkontaktbereich 30, einen Übergangsbereich 32, einen inneren bzw. mittleren Bereich 34 und einen Kontaktstiftbefestigungsbereich 36 aufweist.

Der Federkontaktbereich 18 des Kontaktstifts 12 ist insbesondere dimensioniert und ausgelegt, daß er den Kontaktstiftkontaktbereich 30 der Feder 14 kontaktieren kann. Der Übergangsbereich 32 der Feder 14 ist insbesondere dimensioniert und ausgelegt, daß der Übergangsbereich 32 den Kontaktstift 12, insbesondere den Federkontaktbereich 18 des Kontaktstifts 12 führen kann, damit der Federkontaktbereich 18 des Kontaktstifts 12 mit dem Kontaktstiftkontaktbereich 30 der Feder 14 in Kontakt treten kann, wenn die Feder 14 gestaucht wird.

Der Federbefestigungsbereich 24 des Kontaktstifts 12 ist insbesondere derart dimensioniert und ausgelegt, daß der Federbefestigungsbereich 24 mit dem Kontaktstiftbefestigungsbereich 36 der Feder 14 in Kontakt gelangen kann. Insbesondere sind der Federbefestigungsbereich 24 des Kontaktstifts 12 und der Kontaktstiftbefestigungsbereich 36 der Feder 14 derart aufeinander abgestimmt, daß die Feder 14 an dem Kontaktstift 12 fixiert ist. Beispielsweise kann der Innendurchmesser des Kontaktstiftbefestigungsbereichs 36 kleiner als der Außendurchmesser des Federbefestigungsbereichs 24 sein, so daß zum Montieren der Feder 14 an den Kontaktstift 12 der Kontaktstiftbefestigungsbereich 36 in radialer Richtung gedehnt werden muß und/oder der Federbefestigungsbereich in radialer Richtung gestaucht werden muß. Die Feder 14 ist in dem Kontaktstiftbefestigungsbereich 36 in radialer Richtung derart rückstellfähig ausgebildet, daß eine Kraft entgegen der radialen Richtung von dem Kontaktstiftbefestigungsbereich 36 auf den Federbefestigungsbereich 24 übertragen wird. Entsprechend kann auch der Federbefestigungsbereich 24 in radialer Richtung rückstellfähig ausgebildet sein. Dadurch wird die Feder 14 an dem Kontaktstift 12 fixiert. Beispielsweise kann der Federbefestigungsbereich 24 Vertiefungen in Form von Nuten bzw. Gräben bzw. Rillen 38a, 38b, 38c usw. aufweisen. Wobei jede Rille 38a, 38b, 38c, usw. derart dimensioniert ist, daß eine Windung 40a, 40b, 40c, usw. in genau eine der Rillen 38a, 38b, 38c paßt. Die Rillen 38a, 38b, 38c können in radialer Richtung verschiedene Größen aufweisen, wobei zu dem Vorsprungsbereich 26 hin die Rillen 38a, 38b, 38c größer werden.

Es ist auch möglich, daß der Federbefestigungsbereich 24 Vorsprünge 38a, 38b, 38c usw. aufweist, die als Zylinder mit gleichen oder verschiedenen Radien ausgebildet sind und die in Längsrichtung hintereinander angeordnet sind, wobei die Außendurchmesser der Vorsprünge 38a, 38b, 38c usw. zu dem Vorsprungsbereich 26 hin zunehmen.

Somit kann die Feder 14 derart mit dem Kontaktstift 12 verbunden sein, daß zwischen dem Kontaktstiftbefestigungsbereich 36 der Feder 14 und dem Federbefestigungsbereich 24 des Kontaktstifts 12 ein Kraftschluß aufgrund der Kraft in radialer Richtung vorliegt. Ebenso kann ein Formschluß aufgrund von teilweise hintergreifenden Flächen der Rillen 38a, 38b, 38c, ... und Flächen der Windungen 40a, 40b, 40d... vorliegen.

Zusätzlich oder alternativ können der Kontaktstiftbefestigungsbereich 36 und der Federbefestigungsbereich 24 auch miteinander verschweißt, verklebt und/oder verlötet sein.

Zusätzlich oder alternativ kann der Kontaktstiftbefestigungsbereich 36 eine Hülse umfassen, insbesondere hülsenförmig ausgebildet sein, wobei die Hülse über den Federbefestigungsbereich 24 gepreßt wird und wobei der Innendurchmesser der Hülse kleiner ist als der Außendurchmesser des Federbefestigungsbereichs 24 und somit einen Kraftschluß vorliegen kann. Hierbei kann der Federbefestigungsbereich beispielsweise konisch ausgebildet sein, wobei der Außendurchmesser des Federbefestigungsbereichs 24 zu dem Vorsprungsbereich 26 hin zu nimmt. Ebenso kann die Hülse einen konischen Innendurchmesser aufweisen, der in Richtung zu dem Kontaktbereich hin abnimmt. Es ist auch möglich, daß ein Rastverschluß vorliegt, wobei ein Element des Kontaktstiftes 12 mit einem Element der Feder 14 verrastet.

Vorteilhafterweise wird dadurch erreicht, daß die Feder 14 in einfacher Weise mit dem Kontaktstift 12 verbindbar ist. Insbesondere ist eine einfache manuelle Herstellung des Anschlußkontakts 10 dadurch möglich, daß die Feder 14 über den Kontaktstift 12 gestülpt wird und der Kontaktstiftbefestigungsbereich 36 der Feder 14 mit dem Federbefestigungsbereich 24 des Kontaktstifts 12 verpreßt wird. Insbesondere ist es nicht notwendig, daß Kontaktstift 12 und Feder 14 in ein Gehäuse, das die Form eines Hohlzylinders bzw. einer Hülse aufweist, eingeführt werden müssen und die Hülse in einem weiteren separaten Arbeitsgang verschlossen werden muß. In anderen Worten besteht der Anschlußkontakt 10 vorzugsweise nur aus dem Kontaktstift 12 und der Feder 14 und ist frei von weiteren Elementen, wie z.B. einem Mantel bzw. einer Kapselung bzw. einem Gehäuse usw. Weiterhin vorteilhafterweise ist der Federweg des Anschlußkontaktes nicht durch ein Gehäuse begrenzt. Vielmehr kann die Feder 14 ausschließlich nach gewollten bzw. notwendigen Federeigenschaften ausgewählt werden. Sind die Feder 14 und der Kontaktstift 12 in einem Gehäuse begrenzt, ist dies nicht ohne weiteres möglich, da beispielsweise die Gehäuselänge in die Auswahl der Federeigenschaften eingeht. Insbesondere ermöglicht auch der einstückig ausgebildete Kontaktstift 12, daß der Anschlußkontakt 10 frei von einem Gehäuse ausbildbar ist. Somit ist auch die Feder 14 nicht durch die Gehäuselänge beschränkt, wie dies der Fall ist, falls der Anschlußkontakt zwei Kontaktstifte aufweist, die anhand des Gehäuses verbunden sind. Weiterhin vorteilhafterweise ist der Signalweg gegenüber einem Anschlußkontakt mit zweiteiligem Kontaktstift und Gehäuse verbessert, da lediglich drei statt vier elektrische Übergangskontakte gebildet werden und somit geringerer Signalverlust vorliegt, da das Signal lediglich drei Übergangskontaktwiderstände passieren muß.

Bei einem zweiteiligen Kontaktstift mit Gehäuse tritt ein elektrischer Kontakt und somit auch ein Kontaktwiderstand (1. Kontaktwiderstand) zwischen dem IC und dem Kontaktstift auf, der mit dem IC in Kontakt ist. Ferner tritt ein elektrischer Kontakt und somit auch ein Kontaktwiderstand (2. Kontaktwiderstand) zwischen dem Kontaktstift und dem Gehäuse auf. Weiterhin tritt ein elektrischer Kontakt und somit auch ein Kontaktwiderstand (3. Kontaktwiderstand) zwischen dem Gehäuse und dem Kontaktstift auf, der mit der Auswerteeinrichtung verbunden ist. Schließlich tritt ein elektrischer Kontakt und somit auch ein Kontaktwiderstand (4. Kontaktwiderstand) zwischen dem Kontaktstift und der Auswerteeinrichtung auf. In anderen Worten muß das Signal von dem IC zu der Auswerteeinrichtung über vier elektrische Übergangskontakte verlaufen.

Gemäß der vorliegenden Erfindung liegen lediglich drei Kontakte vor, nämlich zwischen dem IC und dem IC-Kontaktbereich 28 (1. Kontaktwiderstand), zwischen dem Federkontaktbereich 18 und dem Kontaktstiftkontaktbereich 30 der Feder 14 (2. Kontaktwiderstand) sowie dem Kontaktstiftkontaktbereich 30 der Feder 14 und der Auswerteeinrichtung (3. Kontaktwiderstand).

Der Kraftschluß und/oder der Formschluß zwischen dem Kontaktstiftbefestigungsbereich 36 der Feder 14 und dem Federbefestigungsbereich 24 des Kontaktstifts 12 beträgt zwischen etwa 0,1 N und etwa 5 N vorzugsweise zwischen etwa 0,5 n und etwa 2 N.

Der Vorsprungsbereich 26 des Kontaktstifts 12 ist vorzugsweise dazu ausgelegt, daß beispielsweise der Kontaktstiftbefestigungsbereich 26 der Feder 14 daran anschlägt, insbesondere dagegen gedrückt werden kann, um somit in einfacher Weise die Feder 14 und den Kontaktstift 12 miteinander zu montieren. Weiterhin kann der Vorsprungsbereich 26 dazu dienen, daß der Anschlußkontakt 10 in einfacher Weise in einer entsprechenden Öffnung des IC-Testsockels angeordnet, insbesondere montiert werden kann. Beispielsweise ist in dem IC-Testsockel eine Öffnung vorhanden, in die der Anschlußkontakt eingesetzt wird. Die Öffnung wird mit einem Deckel verschlossen, wobei der IC-Kontaktbereich durch eine Öffnung des Deckels durch den Deckel hindurch ragt. Die Öffnung des Deckels ist jedoch kleiner als der Außendurchmesser des Vorsprungsbereichs 26, so daß der Anschlußkontakt 10 in der Öffnung fixiert ist. Da der Anschlußkontakt 10 kein eigenes Gehäuse aufweist, kann somit auch der Federweg der Feder 14 gegenüber einem Anschlußkontakt mit Gehäuse vergrößert werden. Der Vorsprungsbereich 26 muß nicht notwendigerweise zylinderförmig sein. Der Vorsprungsbereich 26 kann (in Aufsicht) auch rechteckig, insbesondere quadratisch, elliptisch geformt sein usw.

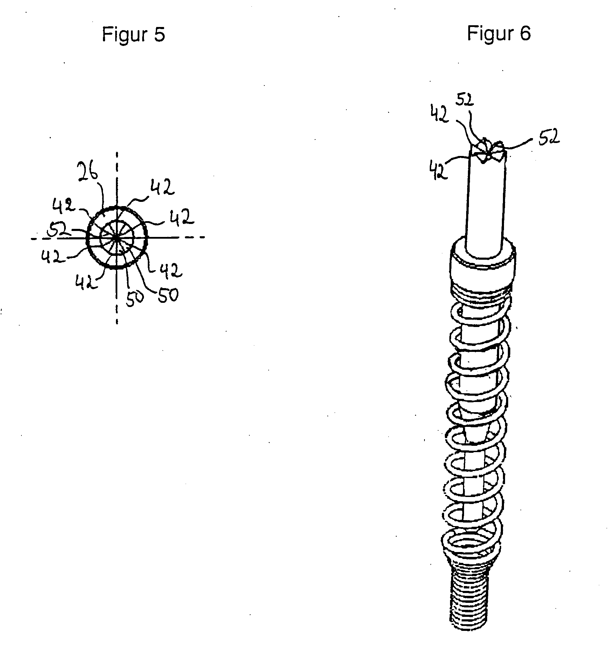

Der IC-Kontaktbereich 28 weist zumindest sechs Kontaktspitzen 42 auf. Anhand der sechs Kontaktspitzen 42 kann mechanischer und/oder elektrischer Kontakt mit entsprechenden Kontaktbereichen des ICs hergestellt werden. Beispielsweise können die Kontaktspitzen 42 mit einer Lötperle des ICs in Kontakt treten, insbesondere die Lötperle verformen, beispielsweise in die Lötperle stechen. Ferner sind zwischen den Kontaktspitzen 42 Kontaktflächen (gezeigt in Figuren 5 und 6) angeordnet. Auch die Kontaktflächen können mit entsprechenden Kontaktstellen des ICs zumindest bereichsweise in Kontakt treten. Vorteilhafterweise wird dadurch erreicht, daß besserer mechanischer und/oder elektrischer Kontakt zwischen dem IC-Kontaktbereich 28 und dem IC herstellbar ist. Anhand der vergrößerten Oberfläche des IC-Kontaktbereichs 28 zwischen den Kontaktspitzen 42 ist auch eine verbesserte kapazitive Kopplung zwischen dem Kontaktstift 12 und dem IC möglich.

Weiterhin wird aufgrund der vergrößerten Oberfläche zwischen den Kontaktspitzen 42 ein geringerer Ohm'scher Widerstand zwischen dem IC-Kontaktbereich 28 und dem entsprechenden Kontakt des ICs hergestellt.

In Figur 1 sind weiterhin beispielhafte Bemaßungen des Anschlußkontakts 10 dargestellt, wobei Figur 1 eine beispielhafte technische Zeichnung einer bevorzugten Ausführungsform des Anschlußkontakts 10 ist. Weitere Ausführungsformen der Anschlußkontakts 10 können andere Maße aufweisen.

Der IC-Kontaktbereich 28 des Anschlußkontakts 10 ist im wesentlichen zylinderförmig mit einem Außendurchmesser zwischen etwa 0,4 mm und etwa 0,2 mm, insbesondere mit einem Durchmesser von etwa 0,3 mm. Der Vorsprungsbereich 26 ist ebenfalls im wesentlichen zylinderförmig mit einem Außendurchmesser zwischen etwa 0,7 mm und etwa 0,3 mm, insbesondere mit einem Durchmesser von etwa 0,55 mm. Die Höhe bzw. Länge des IC-Kontaktbereichs 28 beträgt zwischen etwa 0,9 mm und etwa 1,3 mm, insbesondere beträgt die Länge des IC-Kontaktbereichs 28 etwa 1,1 mm ± 0,08 mm. Die gesamte Länge des Anschlußkontakts 10 beträgt in einem wesentlichen entspannten Zustand der Feder 14 (d.h. in dem Ruhezustand) zwischen etwa 3,9 mm und etwa 5,6 mm, vorzugsweise zwischen etwa 4,9 mm und etwa 5,4 mm insbesondere etwa 5,15 mm. Die gesamte Länge des Anschlußkontakts 10 kann in einem wesentlichen entspannten Zustand der Feder 14 zwischen etwa 4,0 mm und etwa 4,5 mm insbesondere etwa 4,2 mm betragen. Beträgt die Länge des Anschlußkontakts 10 in dem Ruhezustand zwischen etwa 4,9 mm und etwa 5,4 mm, vorzugsweise etwa 5,15 mm, kann der Abstand eines zu den Kontaktspitzen 42 hinweisenden Endes des Vorsprungsbereichs 26 von dem freien Ende der Feder 14, d.h. dem Ende der Feder, welches eine Auswerteeinheit, eine Platine, etc. kontaktieren kann, zwischen etwa 3,8 mm und etwa 4,3 mm, insbesondere etwa 4,05 mm betragen. Die Länge des Kontaktstiftkontaktbereichs 30 beträgt in diesem Fall zwischen etwa 0,4 und etwa 0,8 mm, insbesondere etwa 0,6 mm. Bei einer anderen Länge des Anschlußkontakts 10 sind die vorgenannten Abmessungen entsprechend angepaßt, d.h. vorzugsweise um die Längendifferenz im Ruhezustand der Feder verringert.

Der Kontaktstiftkontaktbereich 30 kann im wesentlichen zylinderförmig sein. Der Kontaktstiftkontaktbereich 30 kann auch zumindest bereichsweise konisch sein.

**Figur 2** zeigt einen Anschlußkontakt 10 gemäß Figur 1, d.h. der Anschlußkontakt 10 hat in dem Ruhezustand der Feder 14 eine Länge zwischen etwa 4,9 mm und etwa 5,4 mm, vorzugsweise etwa 5,15 mm, wobei die Feder 14 bereits teilweise gestaucht ist. Insbesondere ist der Anschlußkontakt 10, wie er in Figur 2 dargestellt ist, im Vergleich zu dem in Figur 1 dargestellten Anschlußkontakt 10 auf eine Gesamtlänge von etwa 4,8 mm gestaucht. Ferner ist der Anschlußkontakt 10 in Figur 2 gegenüber dem Anschlußkontakt 10 in Figur 1 um die Zylinderachse 16 um 30 Grad gedreht dargestellt. Bei einer anderen Länge des Anschlußkontakts 10 sind die vorgenannten Abmessungen entsprechend angepaßt, d.h. vorzugsweise um die Längendifferenz im Ruhezustand der Feder verringert.

Aufgrund der Komprimierung der Feder 14 ragt eine Spitze des Federkontaktbereichs 18 zumindest bereichsweise in den Übergangsbereich 32 der Feder 14. Der Übergangsbereich 32 ist zumindest teilweise konisch ausgebildet.

Dadurch kann beispielsweise die Spitze 44 des Federkontaktbereichs 18 durch die konische Ausbildung des Übergangsbereichs 32 der Feder 14 geführt werden. Wird beispielsweise der Kontaktstift 12 gegenüber der Längsrichtung ausgelenkt, wird aufgrund des Übergangsbereichs 32 bei Komprimierung der Feder 14 sichergestellt, daß die Spitze 44 des Kontaktstifts in den Kontaktstiftkontaktbereich 30 einführbar ist.

Weiterhin sind in Figur 2 zwei Kanten 46a, 46b zweier gegenüberliegender Kontaktspitzen 42 dargestellt. Die Kanten schließen vorzugsweise einen Winkel zwischen etwa 80 und etwa 100 Grad ein, insbesondere einen Winkel von etwa 90 Grad ein.

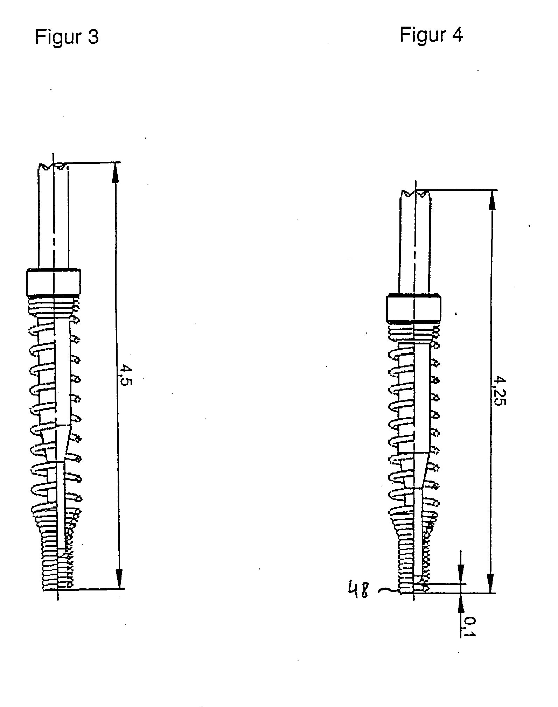

**Figur 3** zeigt den Anschlußkontakt 10 gemäß Figuren 1 und 2, wobei der Anschlußkontakt 10 auf eine Länge von etwa 4,5 mm weiter komprimiert ist. Wie in Figur 3 dargestellt ist, ragt die Spitze 44 des Federkontaktbereichs 18 des Kontaktstifts 12 bereits teilweise in den Kontaktstiftkontaktbereich 30 der Feder 14 hinein. Wird der Anschlußkontakt 10 weiter komprimiert, wie dies beispielsweise in **Figur 4** gezeigt ist, ragt der Federkontaktbereich 18 des Kontaktstifts 12 soweit in den Kontaktstiftkontaktbereich 30 der Feder 14 hinein, daß die Spitze 44 des Kontaktstifts 12 im wesentlichen an der Position der ersten Windung 48 der Feder 14 (vom freien Ende der Feder 14 aus gesehen) ist. Die Länge des in Figur 4 gezeigten Anschlußkontakts 10 beträgt zwischen etwa 4 mm und etwa 4.5 mm, insbesondere 4,25 mm. Die in Figuren 3 und 4 angegebenen Maße gelten vorzugsweise, falls der Anschlußkontakt 10 in dem Ruhezustand der Feder 14 eine Länge zwischen etwa 4,9 mm und etwa 5,4 mm, vorzugsweise etwa 5,15 mm aufweist, Bei einer anderen Länge des Anschlußkontakts 10 sind die vorgenannten Abmessungen entsprechend angepaßt, d.h. vorzugsweise um die Längendifferenz im Ruhezustand der Feder verringert.

Der Kontaktstiftkontaktbereich 30 der Feder 14 kann dabei derart ausgebildet sein, daß der Innendurchmesser des Kontaktstiftkontaktbereichs 30 größer ist als der Außendurchmesser des Kontaktstifts 12. In anderen Worten können Kontaktstift 12 und Feder 14 derart ausgebildet sein, daß der Kontaktstift 12 die Feder 14 vorzugsweise nicht berührt. Der Kontaktstift 12 kann somit eine Auswerteeinrichtung (nicht gezeigt) direkt kontaktieren.

Es ist auch möglich, daß eine oder mehrere Windungen des Kontaktstiftkontaktbereichs 30 einen Innendurchmesser aufweisen, der kleiner ist als der Außendurchmesser des Federkontaktbereichs 18 des Kontaktstifts 12. In anderen Worten kontaktiert der Federkontaktbereich 18 den Kontaktstiftkontaktbereich 30 zumindest an diesen Windungen. Vorzugsweise gilt insbesondere für die erste Windung 48, daß der Federkontaktbereich 18 des Kontaktstifts 12 mit einer Innenfläche der ersten Windung 48 des Kontaktstiftkontaktbereichs 30 in mechanischem und insbesondere elektrischem Kontakt treten kann. Somit kann dabei ein Signal ausgehend von den Kontaktspitzen 42 über den Kontaktstift 12 zu der ersten Windung 48 und auf eine Auswerteeinrichtung bzw. auf ein anderes elektrisches Bauelement übertragen werden.

Figur 1 zeigt den Anschlußkontakt insbesondere in einer entspannten Position bzw. einem entspannten Zustand bzw. Ruhezustand, wenn beispielsweise der Anschlußkontakt 10 im Gravitationsfeld der Erde mit seiner Längsachse im wesentlichen horizontal ausgerichtet ist, und somit keine Kraft auf die Feder entlang der Längsrichtung LR wirkt. Figur 2 zeigt den Anschlußkontakt 10 in einer Position in der der Anschlußkontakt 10 in dem IC-Testsockel montiert ist. Hierbei ist vorzugsweise der Anschlußkontakt 10 im Rotationsfeld der Erde im wesentlichen vertikal ausgerichtet. Somit drückt die Gewichtskraft des Kontaktstifts 12 in der Längsrichtung LR auf die Feder 14 und komprimiert die Feder. Ebenso wird die Feder 14 aufgrund der Abmessungen der Öffnung in dem IC-Testsockel, in der der Anschlußkontakt 10 angeordnet ist, komprimiert. Figur 3 zeigt den Anschlußkontakt 10, wenn der Anschlußkontakt auf einem weiteren elektrischen Element, beispielsweise einer Leiterplatine angeordnet ist. In diesem Fall kontaktiert der Kontaktstiftkontaktbereich bzw. Kontaktbereich 30 der Feder 14 das elektrische Element, insbesondere die Platine (nicht gezeigt), so daß die Feder 14 weiter komprimiert wird. Figur 4 zeigt den Anschlußkontakt 10, wenn der IC-Kontaktbereich 28 mit dem IC in Kontakt ist. Durch das Gewicht des ICs wird der Anschlußkontakt 10 weiter komprimiert. Hierbei zeigt Figur 4 den Anschlußkontakt 10 kurz bevor die Spitze 44 des Federkontaktbereichs 18 die erste Windung 48 kontaktiert. Wenn (im Vergleich zu Figur 4) die Feder um 0,1 mm weiter komprimiert ist, so daß die Spitze 44 des Federkontaktbereichs 18 die erste Windung 48 der Feder 14 kontaktiert, ist der Anschlußkontakt 10 in der Kontaktposition bzw. dem Kontaktzustand. In der Kontaktposition bzw. dem Kontaktzustand hat der Anschlußkontakt 10 eine Länge von etwa 4,15 mm.

Insgesamt kann der Anschlußkontakt 10 ausgehend von einer Ruheposition im Vergleich zu der Position in der die Spitze 44 des Federkontaktbereichs 18 mit der ersten Windung 48 in Kontakt ist, um etwa 1 mm kontrahiert werden.

**Figur 5** zeigt eine Draufsicht des Anschlußkontakts 10, wobei insbesondere die Kontaktspitzen 42 und die die Kontaktspitzen 42 verbindenden Flächen 50 sowie der Vorsprungsbereich 26 gezeigt sind. Die Kontaktspitzen 42 und somit auch Kontaktkanten 52 sind vorzugsweise gleichmäßig über den Umfang des IC-Kontaktbereichs 28 verteilt. Bei einer Anzahl von 6 Kontaktspitzen 42 sind die Kontaktspitzen 42 in einem Winkel von 60° zueinander angeordnet.

**Figur 6** zeigt eine perspektivische Ansicht des Anschlußkontakts 10, wobei ebenfalls insbesondere die Kontaktspitzen 42 und die die Kontaktspitzen 42 verbindenden Flächen 50 sowie die Kontaktkanten 52 gezeigt sind. Der Anschlußkontakt 10, wie in Figur 5 gezeigt, befindet sich in einer entspannten Position bzw. einem Ruhezustand.

### Bezugszeichenliste

- 10: Anschlußkontakt
- 12: Kontaktstift
- 14: Federelement/Feder/Spiralfeder
- 16: Symmetrieachse/Zylinderachse
- 18: Federkontaktbereich
- 20: Übergangsbereich
- 22: innerer Bereich
- 24: Federbefestigungsbereich
- 26: Vorsprungsbereich
- 28: IC-Kontaktbereich
- 30: Kontaktbereich/Kontaktstiftkontaktbereich
- 32: Übergangsbereich
- 34: innerer Bereich
- 36: Kontaktstiftbefestigungsbereich
- 38a: Rille
- 38b: Rille
- 38c: Rille
- 40a: Windung
- 40b: Windung
- 40c: Windung
- 42: Kontaktspitze
- 44: Spitze
- 46a: Kante
- 46b: Kante
- 48: Windung
- 50: Fläche
- 52: Kontaktkanten
- LR: Längsrichtung

## Patentansprüche

1. Anschlußkontakt (10) für einen IC-Testsockel umfassend:
- einen Kontaktstift (12) mit
-- einem Federkontaktbereich (18), der ausgelegt ist, ein Federelement (14) zu kontaktieren,
-- einem IC-Kontaktbereich (28), der ausgelegt ist, einen IC zu kontaktieren und mit
-- einem Federbefestigungsbereich (24), wobei
der Kontaktstift (12) einstückig ausgebildet ist, und wobei der Anschlußkontakt weiterhin
- ein Federelement (14) mit
-- einem Kontaktstiftbefestigungsbereich (36) umfaßt, wobei
der Federbefestigungsbereich (24) und der Kotaktstiftbefestigungsbereich (36) derart miteinander verbunden sind, daß der Kontaktstift (12) und das Federelement (14) aneinander fixiert sind.

2. Anschlußkontakt (10) nach Anspruch 1, wobei der IC-Kontaktbereich (28) zumindest sechs Kontaktspitzen (42) aufweist und die Kontaktspitzen (42) ausgelegt sind, ein Kontaktelement eines ICs zu kontaktieren.

3. Anschlußkontakt (10) nach einem der vorhergehenden Ansprüche, wobei der IC-Kontaktbereich (28) zumindest sechs Kontaktkanten (52) wobei die Kontaktkanten (52) zumindest bereichsweise ausgelegt sind, ein Kontaktelement eines ICs zu kontaktieren und/oder wobei der IC-Kontaktbereich (28) zumindest zwölf Kontaktflächen (50) aufweist und die Kontaktflächen (50) zumindest bereichsweise ausgelegt sind, ein Kontaktelement eines ICs zu kontaktieren, insbesondere kapazitiv mit einem Kontaktelement eines ICs gekoppelt zu sein.

4. Anschlußkontakt (10) nach einem der vorhergehenden Ansprüche, wobei das Federelement (14) und der Kontaktstift (12) derart miteinander verbunden sind, daß der Anschlußkontakt (10) gehäusefrei ist.

5. Anschlußkontakt (10) nach einem der vorhergehenden Ansprüche, wobei das Federelement (14) einen Kontaktbereich (30) umfaßt und der Kontaktbereich (30) ausgelegt ist, ein elektronisches Bauelement, insbesondere eine Leiterplatine zu kontaktieren.

6. Anschlußkontakt (10), wobei der Federbefestigungsbereich (24) des Federelements (14) und der Kotaktstiftbefestigungsbereich (36) des Kontaktstiftes (12) derart miteinander verbunden sind, daß bei Anlegen einer Kraft an dem Federelement (14) mit einer zu einer Längsrichtung (LR) des Anschlußkontakts (10) im wesentlichen parallelen Kraftkomponente zwischen etwa 0,1 N und etwa 2 N das Federelement (14) und der Kontaktstift (12) miteinander verbunden bleiben.

7. Anschlußkontakt (10) nach einem der vorhergehenden Ansprüche, wobei der Kontaktstift (12) und das Federelement (14) derart miteinander verbunden sind, daß der IC-Kontaktbereich (28) außerhalb des Federelements (14) angeordnet ist und der Federkontaktbereich (18) zumindest teilweise, insbesondere vollständig innerhalb des Federelements (14) angeordnet ist.

8. Anschlußkontakt (10) nach einem der vorhergehenden Ansprüche, wobei der Kontaktstift (12) zwischen dem IC-Kontaktbereich (28) und dem Federkontaktbereich (18) in radialer Richtung einen Vorsprung (26) aufweist, und der Vorsprung (26) derart ausgebildet ist, daß das Federelement (14) entlang der Längsrichtung (LR) den Vorsprung (26) nicht passieren kann.

9. Anschlußkontakt (10) nach einem der vorhergehenden Ansprüche, wobei das Federelement (14) zumindest drei Federelementbereiche (30, 32, 34, 36) aufweist und das Federelement (14) in einem inneren Federelementbereich (34) entlang der Längsrichtung (LR) stärker dehnbar und/oder stauchbar ist, als in den verbleibenden Federelementbereichen (30, 32, 34).

10. Anschlußkontakt (10) nach Anspruch 9, wobei das Federelement (14) eine Spiralfeder (14) ist und der Abstand der Spiralwindungen der Spiralfeder (14) des inneren Federelementbereichs (34) größer ist als der Abstand der Spiralwindungen der anderen Federelementbereiche (30, 32, 36) der Spiralfeder (14).

11. Anschlußkontakt (10) nach Anspruch 9 oder 10, wobei das Federelement (14) und der Federkontaktbereich (18) derart angeordnet und ausgebildet sind, daß in einem Ruhezustand (Figur 1) des Anschlußkontakts der Federkontaktbereich (18) und das Federelement (14) berührungslos sind.

12. Anschlußkontakt (10) nach Anspruch 11, wobei das Federelement (14) entlang der Längsrichtung (LR) derart stauchbar ist, daß in einem Kontaktzustand der Federkontaktbereich (18) zumindest eine Windung (48) des Kontaktbereichs (30) berührt.

13. IC-Testsockel mit einem Gehäuse, das eine Vielzahl von Öffnungen aufweist, wobei
- in jeder Öffnung ein Anschlußkontakt (10) gemäß einem der vorhergehenden Ansprüche angeordnet ist,
- die Öffnungen mittels einer gemeinsamen Abdeckung verschlossen sind,
- der Kontaktbereich (30) eines jeden Anschlußkontakts entlang der Längsrichtung (LR) über das Gehäuse des IC-Testsockels hinausragt und wobei
- der IC-Kontaktbereich (28) durch die Abdeckung hindurch ragt und entlang der Längsrichtung (LR) über das Gehäuse des IC-Testsockels hinausragt.

14. Verfahren zum Herstellen eines Anschlußkontakts (10) gemäß einem der Ansprüche 1 bis 12 mit den Schritten:
- Bereitstellen des Kontaktstiftes (12)
- Bereitstellen des Federelements (14)
- Einführen des Kontaktstiftes (12) in das Federelement (14)
- Verbinden des Kontaktstiftbefestigungsbereichs (36) mit dem Federbefestigungsbereich (24).

15. Verfahren nach Anspruch 14, wobei der Kontaktstift (12) soweit in das Federelement (14) eingeführt wird, bis der Kontaktstiftbefestigungsbereich (36) an den Vorsprung (26) stößt.
